# FASCICULE DE BREVET EUROPEEN

(11) **EP 2 510 416 B1**
(45) Date de publication et mention de la délivrance du brevet: **02.11.2016**
(21) Numéro de dépôt: 10809068.9
(22) Date de dépôt: 10.12.2010
(51) Int. Cl.: H01L 31/02, H02J 1/00, G05F 1/67

(54) **SYSTEME DE GESTION ELECTRONIQUE DE CELLULES PHOTOVOLTAIQUES FONCTION DE LA METEOROLOGIE**
ELEKTRONISCHE STEUERUNG VON SOLARZELLEN IN ABHÄNGIGKEIT VOM WETTER
ELECTRONIC CONTROL OF PHOTOVOLTAIC CELLS AS A FUNCTION OF WEATHER CONDITIONS

(30) Priorité: 11.12.2009 FR 0958900
(43) Date de publication de la demande: 17.10.2012
(73) Titulaire: TOTAL MARKETING SERVICES, 92800 Puteaux (FR); Centre National de la Recherche Scientifique, 75794 Paris Cedex 16 (FR)
(72) Inventeur: ALONSO, Corinne, F-31520 Ramonville Saint Agne (FR); BERASATEGI, Alona, E-20213 Idiazabal (Guipuzcoa) (ES); CABAL, Cédric, F-31100 Toulouse (FR); ESTIBALS, Bruno, F-31470 Saint Thomas (FR); PETIBON, Stéphane, F-36130 Deols (FR); VERMEERSCH, Marc, F-78110 Le Vésinet (FR)
(74) Mandataire: Croonenbroek, Thomas Jakob
(86) Numéro de dépôt international: PCT/IB2010/055757
(87) Numéro de publication internationale: WO 2011/070548

(56) Documents cités:
- EP-A1- 1 047 179
- US-A- 4 636 931
- US-B1- 6 259 017
- BLAABJERG F ET AL: "A Review of Single-Phase Grid-Connected Inverters for Photovoltaic Modules", IEEE TRANSACTIONS ON INDUSTRY APPLICATIONS, IEEE SERVICE CENTER, PISCATAWAY, NJ, US LNKD- DOI:10.1109/TIA.2004.841166, vol. 41, no. 5, 1 septembre 2005 (2005-09-01), pages 1292-1306, XP011139229, ISSN: 0093-9994

## Description

### Domaine de l'invention

La présente invention concerne le domaine des générateurs photovoltaïques et plus spécifiquement des modules photovoltaïques intégrant de l'électronique ; un tel module comprend un générateur photovoltaïque et un système de gestion électronique de cellules photovoltaïques.

### Arrière-plan technologique

De manière connue en soi, un générateur photovoltaïque (GPV) comprend une ou plusieurs cellules photovoltaïques (PV) reliées en série et/ou en parallèle. Dans le cas de matériaux inorganiques, une cellule photovoltaïque est essentiellement constituée d'une diode (jonction pn ou pin) composée à partir d'un matériau semiconducteur. Ce matériau présente la propriété d'absorber de l'énergie lumineuse dont une part significative peut être transférée à des porteurs de charge (électrons et trous). La constitution d'une diode (jonction pn ou pin) par dopage de deux zones respectivement de type N et de type P - éventuellement séparées d'une région non dopée (appelée "intrinsèque" et désignée par "i" dans la jonction pin) - permet de séparer les porteurs de charge pour ensuite les collecter via des électrodes que comporte la cellule photovoltaïque. La différence de potentiel maximale (tension de circuit ouvert, V_{oc}) et le courant maximal (courant de court-circuit, I_{cc}) que peut fournir la cellule photovoltaïque sont fonction à la fois des matériaux constitutifs de l'ensemble de la cellule et des conditions environnant cette cellule (dont l'éclairement au travers de l'intensité spectrale, la température,...). Dans le cas des matériaux organiques, les modèles sont sensiblement différents - faisant davantage référence à la notion de matériaux donneurs et accepteurs dans lesquels sont créés des paires électron-trou appelées excitons. La finalité demeure la même : séparer les porteurs de charge pour collecter et générer un courant.

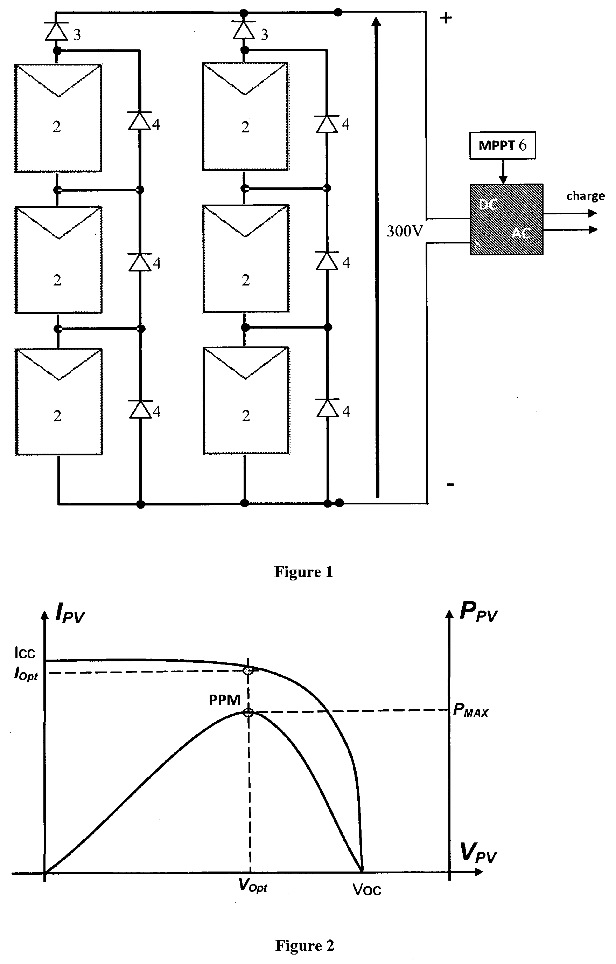

La figure 1 illustre schématiquement un exemple de générateur photovoltaïque (selon l'état de la technique). La plupart des générateurs photovoltaïques sont constitués d'au moins un panneau lui-même constitué de cellules photovoltaïques connectées en série et/ou en parallèle. On peut connecter plusieurs groupes de cellules en série pour augmenter la tension totale du panneau ; on peut également connecter plusieurs groupes de cellules en parallèle pour augmenter l'intensité délivrée par le système. De la même manière, plusieurs panneaux peuvent être reliés en série et/ou en parallèle pour augmenter la tension et/ou l'ampérage du générateur en fonction de l'application.

La figure 1 illustre un générateur photovoltaïque comprenant deux branches parallèles comprenant chacune trois groupes de cellules 2. Afin de garantir la sécurité électrique du générateur photovoltaïque, on peut prévoir des diodes anti-retour 3 et des diodes de dérivation 4 (ou by-pass en terminologie anglaise). Les diodes anti-retour 3 sont branchées en série sur chaque branche parallèle du générateur afin d'éviter la circulation dans les cellules d'un courant négatif arrivant de la charge ou d'autres branches du générateur. Les diodes de dérivation 4 sont branchées en anti-parallèle sur des groupes 2 de cellules. Les diodes de dérivation 4 permettent d'isoler un groupe 2 de cellules présentant une défaillance ou un problème d'ombrage et résolvent le problème de points chauds (ou « hot spot » en terminologie anglaise).

La tension maximale du générateur correspond à la somme des tensions maximales des cellules qui le constituent et le courant maximal que peut délivrer le générateur correspond à la somme des courants maximums des cellules. La tension maximale V_{oc} d'une cellule est atteinte pour une cellule prise à vide, c'est-à-dire pour un courant débité nul (circuit ouvert) et le courant maximal I_{cc} d'une cellule est atteint lorsque ses bornes sont court-circuitées, c'est-à-dire pour une tension nulle aux bornes de la cellule. Les valeurs maximales V_{oc} et I_{cc} dépendent de la technologie et du matériau employés pour réaliser la cellule photovoltaïque. La valeur maximale du courant I_{cc} dépend aussi fortement du niveau d'ensoleillement de la cellule. Une cellule photovoltaïque présente ainsi une caractéristique courant/tension (I_{PV}, V_{PV}) non linéaire et une caractéristique de puissance avec un point de puissance maximal (PPM ou MPP anglais) qui correspond à des valeurs optimales de tension Vₒₚₜ et de courant Iₒₚₜ La figure 2 représente les caractéristiques courant-tension (I_{PV,}V_{PV}) et de puissance - tension (P_{PV}, V_{PV}) d'une cellule photovoltaïque avec son point de puissance maximal (identifié par PPM sur la figure). De même, un générateur photovoltaïque présentera une caractéristique courant/tension non linéaire et une caractéristique de puissance avec un point de puissance maximal. Si une partie des cellules est ombragée, ou si une ou plusieurs cellules d'un groupe sont défectueuses, le point de puissance maximal MPP de ce groupe sera déplacé.

Il est connu d'optimiser le fonctionnement d'un générateur photovoltaïque par l'utilisation d'une commande de recherche du point de puissance maximal (ou MPPT soit Maximum Power Point Tracker en terminologie anglaise). Une telle commande MPPT peut être associée à un ou plusieurs convertisseur(s) statique(s) (CS) qui, selon les applications, peut être un convertisseur courant continu - courant alternatif (DC/AC selon l'acronyme utilisé en anglais) ou un convertisseur courant continu-courant continu (DC/DC selon l'acronyme utilisé en anglais). La figure 1 montre ainsi un convertisseur statique 8 DC/AC branché en sortie du générateur et récoltant l'énergie électrique produite par l'ensemble des cellules du générateur pour la délivrer à une charge. Selon les besoins de la charge, le convertisseur peut être amené à augmenter ou abaisser la tension de sortie et/ou à onduler la tension de sortie. La figure 1 montre aussi une commande MPPT 6 associée au convertisseur 8.

La commande MPPT 6 est conçue pour commander le ou les convertisseur(s) 8 afin d'obtenir une tension d'entrée qui corresponde à la valeur optimale de tension Vₒₚₜ du générateur photovoltaïque (GPV), correspondant au point maximal de la caractéristique de puissance. Le point de puissance maximal dépend de plusieurs paramètres variables au cours du temps, notamment l'ensoleillement en présence, la température ou le vieillissement des cellules ou le nombre de cellules en état de fonctionnement.

De cette manière, le rendement du générateur photovoltaïque n'est pas trop affecté par le dysfonctionnement ou l'ombrage de certaines cellules. Le rendement électrique du générateur dépend directement de l'état de chaque cellule photovoltaïque.

En fonction de l'ensoleillement, la puissance délivrée par le générateur photovoltaïque va varier. Notamment, on pourra utiliser en fonction de la puissance non pas un mais deux ou trois, voire plus, convertisseurs. La méthode consiste à adapter le nombre de convertisseurs (de cellules ou de phases) en fonction de l'évolution de la puissance produite par le GPV. En effet, l'utilisation d'un seul convertisseur n'est pas forcément avantageuse pour gérer de grandes variations de puissance, le rendement de conversion étant affecté. Un convertisseur de puissance constitué à partir d'une seule phase (ou d'un seul convertisseur) a son rendement qui diminue lorsque la puissance PV fournie est maximale, tandis que la structure comprenant trois convertisseurs a tendance à maintenir un rendement quasiconstant quelque soit la puissance PV délivrée. Ce qui va se traduire par un transfert d'énergie à la batterie plus important.

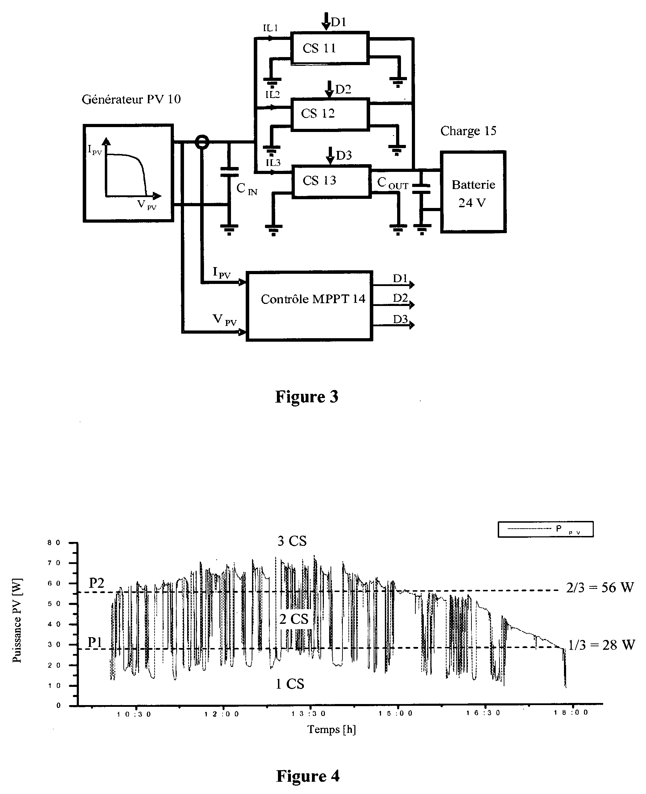

La figure 3 représente un tel arrangement, comprenant à la sortie des cellules PV trois CS (qui sont ici des convertisseurs élévateurs ou BOOST). Ces convertisseurs sont actionnés en fonction de la puissance générée, par rapport à la puissance crête du dispositif (Pcrête). De façon connue, lorsque la puissance délivrée par le GPV est inférieure ou égale à un tiers de la Pcrête, on utilise un CS ; lorsque la puissance délivrée par le GPV est comprise entre 1/3 et 2/3 de la Pcrête, on utilise 2 CS et lorsque la puissance délivrée est supérieure à 2/3 de Pcrête, on utilise 3 CS.

Lors de changements météorologiques, le nombre de convertisseurs sollicités va donc changer, puisque la puissance générée par le GPV va varier US 4636931A divulgue un tel arrangement. Ces changements peuvent être nombreux au cours d'une journée et sur la durée de vie du GPV. Des changements nombreux sollicitent les composants notamment ceux des convertisseurs, ce qui provoque un vieillissement des dispositifs.

Il existe donc un besoin pour diminuer le vieillissement des composants du GPV.

### Résumé de l'invention

Ainsi, l'invention fournit un système de gestion électronique d'un générateur photovoltaïque, le système comprenant :
- une pluralité de n convertisseurs (11, 12, 13) statiques associés en parallèle, chaque convertisseur (11, 12, 13) étant connecté électriquement à au moins une cellule (10) photovoltaïque dudit générateur,
- la variation du nombre de convertisseurs connectés se faisant par variation de la puissance photovoltaïque, par comparaison de la puissance générée à des seuils P1, P2, ... Pn-1, après un temps de temporisation t.

Selon un mode de réalisation, le temps t de temporisation est compris entre 3 et 20 minutes, de préférence entre 5 et 15 minutes.

Selon un mode de réalisation, la valeur du temps t dépend de l'état des composants des convertisseurs.

Selon un mode de réalisation, la valeur du temps t dépend des conditions météorologiques, choisies notamment parmi le lieu d'implantation du générateur et la saison.

Selon un mode de réalisation dit de rotation des CS, dans le système, les convertisseurs sont connectés à tour de rôle.

Selon une variante de ce mode de réalisation avec rotation des CS, la rotation des convertisseurs se fait lors de la variation du nombre de convertisseurs engagés.

Selon une variante de ce mode de réalisation avec rotation des CS, la rotation des convertisseurs dépend de l'état des composants des convertisseurs.

L'invention a encore pour objet un générateur photovoltaïque comprenant :
- au moins une cellule photovoltaïque;
- le système de gestion selon l'invention.

L'invention a encore pour objet un procédé de commande d'un générateur photovoltaïque comprenant :
- au moins une cellule photovoltaïque;
- une pluralité de n convertisseurs (11, 12, 13) statiques associés en parallèle, chaque convertisseur (11, 12, 13) étant connecté électriquement à au moins une cellule (10) photovoltaïque;
ledit procédé comprenant les étapes de :
- détermination de la puissance générée par ladite au moins une cellule photovoltaïque et comparaison avec la puissance de crête;
- comparaison avec des valeurs seuils P1, P2, ... Pn-1;
- connexion de i convertisseurs lorsque la valeur de puissance mesurée est comprise entre Pi-1 et Pi ou de tous les convertisseurs si la valeur de puissance mesurée est supérieure à Pn-1 ;
- ladite connexion étant effectuée après un temps de temporisation t si les conditions de connexion sont toujours remplies.

Selon un mode de réalisation, ledit procédé comprend les étapes suivantes, mises en oeuvre selon des périodes :
- détermination de la puissance générée par ladite au moins une cellule photovoltaïque et comparaison avec la puissance de crête;
- comparaison avec la valeur seuil P1;
   (a)- si la valeur est inférieure à ce seuil P1, un seul convertisseur est connecté;
   (b) si la valeur est supérieure à ce seuil P1, on compare ensuite à un second seuil P2;
   (b1) si la puissance est inférieure à P2, 2 convertisseurs sont connectés;
   (b11) on compare ensuite au premier seuil P1, et si la valeur de puissance est supérieure à ce seuil la routine retourne à l'étape (b) et si la valeur est inférieure à ce seuil P1, il y a déclenchement d'une temporisation t;
   (b12) si la temporisation a été déclenchée, on compare ensuite encore au premier seuil P1, et si la valeur de puissance est supérieure à ce seuil la routine retourne à l'étape (b) après avoir remis la temporisation à zéro et si la valeur est inférieure à ce seuil P1, il y a détermination de l'écoulement ou non de la durée de temporisation et si non reprise de la comparaison à la valeur P1;
   (b13) lorsque la durée de temporisation est écoulée, il y a alors retour à l'étape (a)
   (b2) si la puissance est supérieure à P2, 3 convertisseurs sont connectés;
   (b21) on compare ensuite au second seuil P2, et si la valeur de puissance est supérieure à ce seuil la routine retourne à l'étape (b2) et si la valeur est inférieure à ce seuil P1, il y a déclenchement d'une temporisation t;
   (b22) si la temporisation a été déclenchée, on compare ensuite encore au second seuil P2, et si la valeur de puissance est supérieure à ce seuil la routine retourne à l'étape (b2) après avoir remis la temporisation à zéro et si la valeur est inférieure à ce seuil P2, il y a détermination de l'écoulement ou non de la durée de temporisation et si non reprise de la comparaison à la valeur P2;
   (b13) lorsque la durée de temporisation est écoulée, il y a alors retour à l'étape (a) ou à l'étape (b);
- répétition des étapes le cas échéant pour n convertisseurs.

Selon un mode de réalisation dit de rotation des CS, dans le procédé selon l'invention :
- le ième convertisseur n'étant plus connecté lors de la connexion des autres convertisseurs lorsque tous les convertisseurs ne sont pas connectés.

Selon une variante de ce mode de réalisation avec rotation des CS, le procédé comprend les étapes de :
- connexion d'au moins un premier convertisseur ;
- connexion d'un nombre plus élevé de convertisseurs ;
- puis lors de la connexion d'un nombre moins élevé de convertisseurs, ledit premier convertisseur n'est pas connecté.

Selon une variante de ce mode de réalisation avec rotation des CS, dans le procédé, l'étape de rotation des convertisseurs s'effectue lorsque la valeur de puissance mesurée change entre les seuils Pi-1 et Pi.

Selon une variante de ce mode de réalisation avec rotation des CS, le procédé comprend les étapes de :
- détermination de la durée d'utilisation et/ou du nombre d'utilisation de chaque convertisseur ;
- connexion des convertisseurs tels que la durée d'utilisation et/ou le nombre d'utilisation est sensiblement égal pour les convertisseurs sur une période donnée.

Les procédés de l'invention sont particulièrement adaptés aux générateurs selon l'invention.

### Brève description des dessins

Dans les dessins annexés :
- figure 1, déjà décrite, un schéma d'un générateur photovoltaïque de l'état de la technique ;
- figure 2, déjà décrite, des caractéristiques courant-tension et de puissance théoriques d'une cellule photovoltaïque ;
- figure 3, montre un schéma d'un GPV comprenant plusieurs convertisseurs (ici 3 convertisseurs statiques CS type BOOST) ;
- figure 4, montre l'évolution de la puissance et du nombre de CS engagés en fonction de l'heure de la journée ;
- figure 5, montre l'algorithme selon un mode de réalisation de l'invention ;
- figures 6a et 6b, montrent un agrandissement de deux zones de la courbe de puissance en fonction du moment de la journée avec application de l'invention et indication du nombre de CS engagés ;
- figure 7, montre un exemple de profil de production photovoltaïque, puissance PV (P_{PV}) en fonction du temps.
- figure 8, montre un profil de puissance simulé ;
- figures 9a et 9b, représentent les valeurs de Pᵢₙ et Pₒᵤₜ dans les cas sans et avec algorithme de l'invention ;
- figure 10, représentant le dispositif de mesure utilisé.

Dans les figures 4, 6a, 6b, 7, 8, 9a et 9b, les seuils P1 et P2 sont de façon classique à 1/3 et 2/3 de la puissance Pcrête, soit ici 28 et 56W, respectivement.

### Description détaillée de modes de réalisation de l'invention.

L'invention propose un système de gestion électronique d'un générateur photovoltaïque comprenant une pluralité de convertisseurs (de cellules ou de phases) qui peuvent être DC/AC ou DC/DC, typiquement trois convertisseurs, reliés à des cellules photovoltaïques. Les convertisseurs sont connectés électriquement à au moins une cellule photovoltaïque afin de récolter l'énergie produite par cette cellule et la transférer vers une charge. On appelle « charge » l'application électrique à laquelle est destinée l'énergie produite par le générateur photovoltaïque. La description qui suit est donnée en référence à 3 convertisseurs, mais il est entendu que l'invention s'applique identiquement à un nombre supérieur. CS sera l'acronyme utilisé dans ce qui suit pour désigner un convertisseur (ici statique).

Ces convertisseurs sont, de façon classique, commandés par une commande dite MPPT. Par exemple, cette commande de recherche du point de puissance maximal MPPT peut mettre en oeuvre un algorithme qui identifie l'influence d'un changement de tension sur la puissance délivrée par le générateur et provoque un décalage de la tension dans le sens identifié comme accroissant la puissance. Ainsi, un tel algorithme consiste à mesurer la puissance délivrée par le générateur pour une première tension et, après un certain temps, à imposer une deuxième tension supérieure à la première puis mesurer ou estimer la puissance correspondante. Dans le cas où la puissance correspondant à la seconde tension est supérieure à la puissance correspondant à la première tension, l'étape suivante de l'algorithme est d'imposer une troisième tension encore plus grande. Dans le cas contraire, la troisième tension appliquée est plus faible que la première tension. Ainsi, de proche en proche, le système peut adapter en permanence la tension aux bornes du générateur photovoltaïque afin de se rapprocher le plus possible du point de puissance maximum. Il est entendu que d'autres algorithmes peuvent être mis en oeuvre pour la commande MPPT.

La figure 3 représente un tel schéma, et le GPV comprend une unité photovoltaïque 10, reliée à des CS 11, 12 et 13 (BOOST 1, 2 et 3) et à une commande MPPT 14, la sortie des CS étant reliée à une batterie 15.

Le nombre de CS engagés est fonction de la puissance qui est envoyée vers les CS. De façon connue, le nombre varie selon la détection d'un seuil. Dans le cas de 3 CS, l'application de l'état de la technique correspond à deux seuils prédéterminés de changement du nombre de convertisseur. En fonction de la puissance mesurée par le système de gestion MPPT, savoir moins de 1/3 Pcrête, entre 1/3 et 2/3 Pcrête et plus de 2/3 Pcrête, alors le système de gestion engage un, deux ou trois convertisseurs. D'autres valeurs de seuils peuvent être utilisées, le cas échéant.

Les conditions météorologiques sont responsables, bien entendu, du niveau de puissance générée. Lorsque le soleil est caché par des nuages épais, l'ensoleillement diminue fortement, et la puissance générée chute, ce qui conduit à un changement dans le système, qui passe de 3 à 1 CS. Pour un changement inverse, c'est le contraire qui se produit. Ces changements sont notamment donnés en exemple dans la figure 4. On a représenté dans la figure 4 la puissance générée et le nombre de CS engagés en fonction de l'heure de la journée. Lors de l'utilisation de cette configuration avec multiples CS et adaptation du nombre de CS pour des applications photovoltaïques, on peut s'apercevoir que pour des journées de fonctionnement perturbées, tel que l'on peut le voir en figure 4, le dispositif va changer souvent et rapidement le nombre de convertisseur pour suivre les variations climatiques et donc les variations de puissance photovoltaïque. Ces changements rapides et nombreux vont avoir un impact négatif sur la durée de vie et sur la fiabilité des composants électroniques constituant les convertisseurs de puissance.

L'invention est basée sur l'utilisation d'un temps t de stabilisation de la puissance (ou temporisation). Le changement du nombre de CS ne sera autorisé qu'après l'expiration de ce temps t ou temporisation (« lag time »). Ainsi, une variation rapide ne sera pas prise en compte et le nombre de CS restera identique pendant la phase comprenant des oscillations.

Ce temps t de stabilisation varie en fonction du système. Il peut être typiquement de l'ordre de 3 minutes à 20 minutes, par exemple compris entre 5 minutes et 15 minutes.

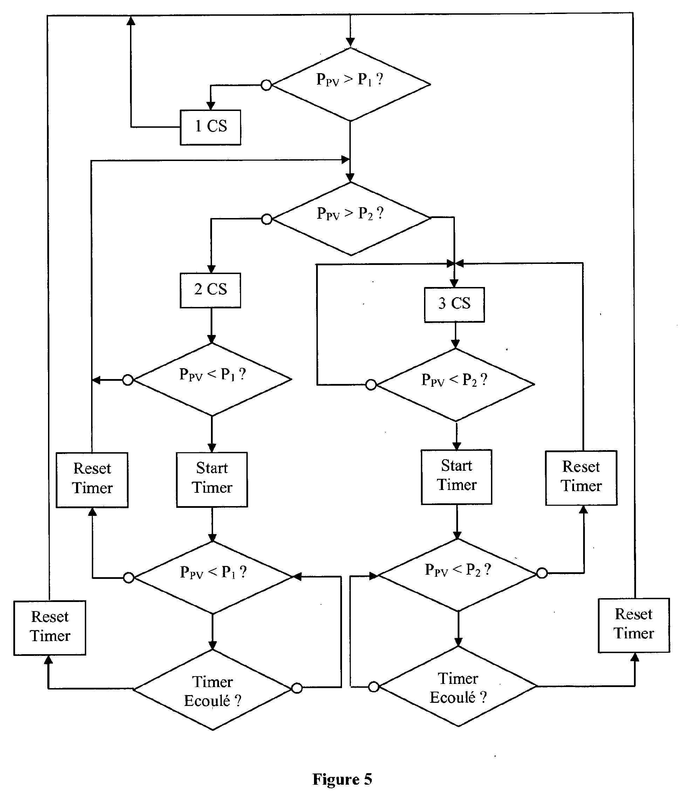

Un algorithme possible pour la mise en oeuvre du temps t de stabilisation est donné à la figure 5.

On part d'un état avec une puissance donnée. Dans un premier temps, on détermine la puissance PV, P_{PV}, (qui correspond à P_{IN} pour les CS).

Si cette puissance P_{PV} est inférieure au premier seuil P1 (pris par exemple égal à 1/3), alors la réponse à la question logique est « non » et un seul CS est engagé ; la routine retourne au début. Si cette puissance P_{PV} est supérieure au premier seuil, alors la réponse à la question logique est « oui » ; alors on passe à la seconde étape de la routine.

Au cours de cette seconde étape, on compare au second seuil P2 (pris par exemple égal à 2/3). Si cette puissance P_{PV} est inférieure au second seuil P2 (pris par exemple égal à 2/3), alors la réponse à la question logique est « non » et deux CS sont alors engagés ; la routine continue alors selon une première branche.

Selon cette première branche la prochaine question logique est à nouveau une comparaison au premier seuil P1. Si la puissance P_{PV} est supérieure au premier seuil P1, alors la réponse à la question logique est « non » et la routine retourne au début de la seconde étape. Si la réponse est oui, alors il y déclenchement de la temporisation. Selon l'état de la technique, la réponse entrainait nécessairement le passage à 1 CS. Dans l'invention, ce passage ne se fait pas et à la place on déclenche une temporisation. De temps à autre, selon une période définie on mesure et on compare encore la valeur de la puissance P_{PV} au premier seuil P1. Si la valeur est supérieure, alors la réponse à la question logique est « non » et la routine retourne au début de la seconde étape : on est encore dans les conditions dans lesquelles il faut 2 CS. On remet à zéro la temporisation dans ce cas. On voit donc que le fait d'avoir attendu a permis de ne pas faire un aller-retour entre 2 états et donc de gagner en terme de fatigue des composants du système. Si lors de la comparaison la valeur est inférieure au seuil P1, alors on passe à la question logique suivante. La question logique suivante est la question de l'écoulement de la temporisation.
- Si la réponse est négative, on retourne à la question logique précédente qui est la comparaison avec la valeur de seuil P1. Donc si au cours de la période de temporisation t la valeur de puissance P_{PV} est supérieure au premier seuil P1, le système considère que le nombre était en fait de 2 CS et le système retourne à la question logique de la deuxième étape.
- Si la réponse est positive, alors cela signifie que le temps de temporisation est écoulé, on remet la temporisation à zéro, on passe à 1 CS et on recommence complètement la séquence.

Au cours de cette seconde étape, on compare au second seuil P2 (pris par exemple égal à 2/3). Si cette puissance P_{PV} est supérieure au second seuil P2 (pris par exemple égal à 2/3), alors la réponse à la question logique est « oui » et 3 CS sont alors engagés ; la routine continue alors selon une seconde branche.

Selon cette seconde branche la prochaine question logique est à nouveau une comparaison au second seuil P2. Si la puissance P_{PV} est supérieure au second seuil P2, alors la réponse à la question logique est « non » et la routine retourne au début de la seconde branche. Si la réponse est oui, alors il y déclenchement de la temporisation. Selon l'état de la technique, la réponse entrainait nécessairement le passage à 2 (ou 1) CS. Dans l'invention, ce passage ne se fait pas et à la place on déclenche une temporisation. De temps à autre, selon une période définie on mesure et on compare encore la valeur de la puissance P_{PV} au second seuil P2. Si la valeur est supérieure, alors la réponse à la question logique est « non » et la routine retourne au début de la seconde branche : on est encore dans les conditions dans lesquelles il faut 3 CS. On remet à zéro la temporisation dans ce cas. On voit donc que le fait d'avoir attendu a permis de ne pas faire un aller-retour entre 2 états et donc de gagner en terme de fatigue des composants du système. Si lors de la comparaison la valeur est inférieure au seuil P2, alors on passe à la question logique suivante. La question logique suivante est la question de l'écoulement de la temporisation.
- Si la réponse est négative, on retourne à la question logique précédente qui est la comparaison avec la valeur de seuil P2. Donc si au cours de la période de temporisation t la valeur de puissance P_{PV} est supérieure au premier seuil P2, le système considère que le nombre était en fait de 3 CS et le système retourne à la question logique de la deuxième branche.
- Si la réponse est positive, alors cela signifie que le temps de temporisation est écoulé, on remet la temporisation à zéro, on passe à 1 CS et on recommence complètement la séquence. On pourrait aussi passer non pas à 1 CS mais à 2 CS et recommencer identiquement, la réponse à la première question logique amenant nécessairement à la seconde.

Selon un mode de réalisation, lors de la montée en puissance, il n'y a pas de temporisation. On évite que toute la puissance soit dirigée vers un seul CS, ce qui impliquerait une augmentation brutale de la température du CS.

La période définie visée supra est fixée ou peut varier en fonction de certaines conditions, notamment météorologiques : il n'est pas besoin de mettre en oeuvre la routine avec un ensoleillement que l'on sait constant. La durée de cette période est très variable, et peut être de l'ordre de la seconde, de la dizaine de secondes, de la minute voire plus le cas échéant. La période restera cependant avantageusement inférieure à la durée t de stabilisation.

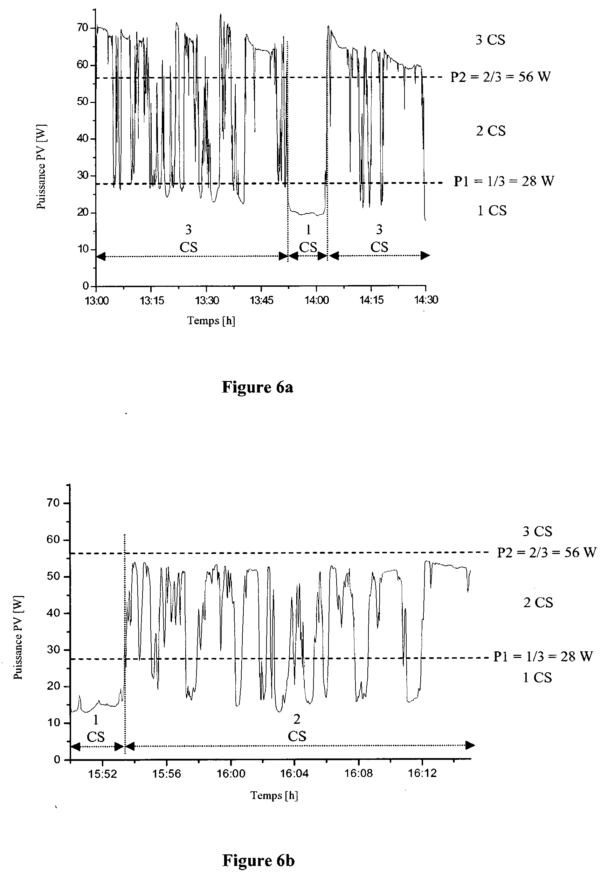

Les figures 6a et 6b montrent, de façon agrandie, le nombre de CS engagés avec la mise en oeuvre de l'algorithme selon l'invention, pour deux parties prises dans la courbe de la figure 4.

On voit sur ces figures 6a et 6b que le cas 2 CS n'est pas un cas actif, le système ayant considéré que le cas 3 CS est le cas prépondérant. Dans la figure 6a, les variations sont entre 3 CS et 2 CS majoritairement, avec une très grande partie dans le domaine 3 CS. Dans un tel cas, le système considère que le GPV fonctionnera avec moins de sollicitations dans le cas 3 CS. Cette situation est encore plus flagrante dans la figure 6b, puisque le cas 2 CS aurait été plus souvent mis en oeuvre avec l'état de la technique, alors qu'il ne se produit pas avec l'invention. L'invention favorise le cas supérieur, lorsque le GPV balance entre 2 états.

L'utilisation de ce temps de stabilisation a pour effet de réduire les stress thermique et électrique subis par les composants actifs lors de ces variations intempestives de puissance.

Les variations thermiques induisent des contraintes mécaniques au niveau des semiconducteurs, dues en grande partie à la différence au niveau des coefficients de dilatation des matériaux utilisé lors de la fabrication, par exemple 4ppm/°C pour le silicium contre 16ppm/°C pour le cuivre et 24ppm/°C pour l'aluminium.

Le résultat des contraintes mécaniques subies par des contacts électriques après de nombreux cycles thermiques est l'apparition de microfissures sur les contacts, allant même jusqu'à la rupture de celui-ci.

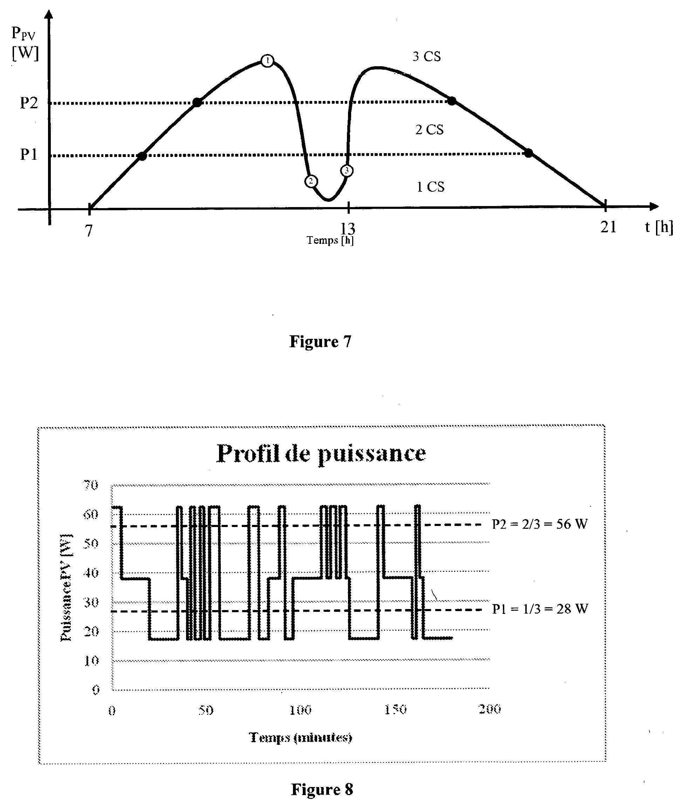

L'invention a pour but d'anticiper les variations pour minimiser les cycles thermiques en limitant les variations brusques de température. La figure 7 est un exemple de profil de production photovoltaïque, puissance PV (P_{PV}) en fonction du temps. En milieu de journée, par exemple on observe une chute brutale de la puissance. En fonctionnement normal, le système va passer du point 1 (forte puissance - 3 convertisseurs activés) au point 2 (faible puissance -1 seul convertisseur activé). Deux convertisseurs vont donc s'arrêter brusquement créant donc un cycle thermique de fort ΔT°.

En appliquant l'invention, les trois convertisseurs continueront à fonctionner au point 2. La température des trois convertisseurs va donc diminuer progressivement car la puissance est répartie dans les trois cellules. Si la puissance n'a pas augmenté entre les points 2 et 3, deux des convertisseurs seront déconnectés et donc un seul convertisseur fonctionnera au point 3. Grâce à ce principe, il est possible de limiter l'importance des variations ΔT° et donc limiter l'importance des cycles thermiques.

Le temps t de stabilisation, ou temporisation, est le temps pendant lequel les 3 CS seront actifs entre les points 2 et 3 (ou une autre combinaison de CS).

Ce temps t de stabilisation ou temporisation peut être fixé dans l'algorithme du système ou il peut être modifié en fonction de plusieurs critères.

Un premier critère est la météorologie elle-même. Les conditions climatiques varient d'une zone à l'autre et donc la temporisation peut être optimisée en fonction de la zone dans laquelle est implanté le GPV. En effet, dans certains climats, il y a peu de nuages alternant (par exemple un climat méditerranéen) ou au contraire il peut y en avoir beaucoup (par exemple un climat océanique). Les conditions climatiques varient aussi en fonction des saisons, et la temporisation peut encore être adaptée en fonction du mois d'utilisation.

Il est aussi possible d'avoir des logiciels d'apprentissage « intelligents » qui vont classifier les conditions climatiques et choisir la durée de la temporisation en fonction des conditions climatiques effectivement rencontrées.

Un second critère est le comportement des composants eux-mêmes, et notamment leur comportement en fonction de la puissance, de la température (notamment des transistors ou de l'ensemble du système). Le temps t de stabilisation ou temporisation pourra notamment être modulé en fonction de la température des composants.

Selon un mode de réalisation avantageux, le système intègre une routine de rotation des CS pour éviter la sollicitation en continue d'un seul CS. En effet, dans la figure 3, le convertisseur CS 11 est relié en permanence, et donc reçoit le courant à convertir en permanence. Les autres CS sont utilisés en fonction des changements intervenant dans la génération de la puissance PV. Le CS 11 est donc sollicité en permanence, et est soumis en outre à des changements de puissance à traiter lors des variations de puissance PV. La fiabilité du système est donc diminuée puisqu'un des composants est sollicité en permanence. Selon le mode de réalisation avantageux, il y a une rotation des CS engagés.

La rotation peut être commandée lors des changements de puissance PV générée par les panneaux ou peut être commandée en fonction de l'état des convertisseurs, ou les deux. Une commande aléatoire d'affectation peut aussi être utilisée.

Selon un mode de réalisation, le changement de CS a lieu lors de l'augmentation du nombre de CS engagés. Par exemple, si le CS 11 est connecté, et que la commande détermine qu'il faut utiliser 2 CS, alors ce seront les CS 12 et 13 qui seront engagés, tandis que le CS 11 ne sera plus connecté. Si le nombre de CS revient à une unité, alors ce sera le CS 12 (ou CS 13) qui sera connecté, plutôt que le CS 11 qui sera encore au repos. Dans le cas où les 3 CS doivent être connectés, la rotation a lieu lors du retour à 1 ou 2 CS. Dans ce cas, on part d'une situation ou le CS 11 est connecté, puis les 3 CS sont connectés, puis les conditions de retour requièrent 2 CS alors les CS 12 et 13 sont connectés ou si les conditions de retour requièrent seulement 1 CS, ce sera le CS 12 ou 13 qui sera connecté.

Selon un autre mode de réalisation, le changement de CS a lieu du fait d'un calcul d'utilisation des CS. Ce calcul peut être basé sur la durée d'utilisation, la rotation se fait de sorte à assurer une durée d'utilisation sensiblement égale pour tous les CS, sur une période donnée. Cette période peut être une journée, plusieurs journées ou une fraction de journée, par exemple une ou plusieurs heures, cette durée pouvant aussi être fonction de l'heure de la journée et/ou de la saison. Ainsi, selon ce mode de réalisation, le CS qui doit être engagé est celui qui a été le moins utilisé, savoir celui ayant eu le temps d'utilisation le plus faible. Le calcul peut aussi se faire en comptant non pas la durée mais le nombre d'utilisation ou de sollicitations du CS, indépendamment de la durée d'utilisation. Ainsi, selon ce cas, le CS qui doit être engagé est celui qui a été sollicité le moins de fois. Il est aussi possible d'envisager un mode de réalisation dans lequel les deux variantes sont associées.

Selon un autre mode de réalisation, il est possible que la rotation se fasse de façon aléatoire, un générateur aléatoire étant alors prévu dans le système de gestion. Lors de l'augmentation ou de la baisse du nombre de CS, le choix se fait de façon aléatoire, éventuellement en mode dit « shuffle » si besoin (ce mode correspond à un mode dans lequel le CS qui a été utilisé est exclu de la sélection aléatoire).

Dans ce qui a été décrit ci-dessus, la rotation des CS se fait lors du changement du nombre de CS engagés. Il est bien entendu possible de prévoir que cette rotation se fasse lorsque le nombre de CS engagés est constant (pour autant qu'il soit différent du nombre maximal). Ainsi, lorsque les conditions météorologiques sont telles que seul un CS est engagé, on peut prévoir une routine qui échange ce CS avec un CS initialement au repos, de sorte qu'un CS ne soit pas utilisé en continu plus d'une durée donnée.

La rotation des convertisseurs engagés a pour effet de réduire encore les stress thermique et électrique subis par les composants actifs lors des variations de puissance. Comme indiqué ci-dessus, les variations thermiques induisent des contraintes mécaniques au niveau des semiconducteurs, dont le résultat est l'apparition de microfissures sur les contacts, allant même jusqu'à la rupture de celui-ci. Le mode de réalisation de rotation des CS a pour but de répartir sur tous les convertisseurs le stress thermique et électrique.

Le système de gestion électronique selon l'invention peut également inclure des fonctions de sécurité, commandant l'arrêt des convertisseurs, suite à un message par exemple de surchauffe des composants du GPV. Le système de gestion électronique selon l'invention peut également inclure une fonction anti-vol. Le système de gestion selon l'invention peut en outre transmettre des informations relatives à l'état de fonctionnement des groupes de cellules et/ou des convertisseurs à un central d'un réseau électrique. Cela permet de faciliter la maintenance des GPV. En particulier, l'opérateur chargé de la maintenance est ainsi averti plus vite d'un dysfonctionnement de certains groupes de cellules photovoltaïques ou de certains convertisseurs et peut prendre des mesures en conséquence.

Le système de gestion selon l'invention peut être tout ou partie intégré dans un générateur photovoltaïque.

Selon un mode de réalisation possible, des dispositifs photovoltaïques multi-jonctions peuvent être utilisés. Il devient alors nécessaire de gérer le problème du couplage électrique des différentes jonctions. Un dispositif photovoltaïque multi jonctions, par exemple à jonction tandem, désigne un dispositif photovoltaïque constitué de plusieurs jonctions simples empilées de façon à accroître la zone d'absorption de spectre solaire par le dispositif. Les dispositifs photovoltaïques à jonction tandem permettent d'obtenir un meilleur rendement de conversion électrique. L'inconvénient principal du couplage électrique dans un dispositif photovoltaïque à jonction tandem est la nécessité d'un accord des performances des cellules photovoltaïques constituant le tandem, quelles que soient les conditions d'ensoleillement. Ce cas idéal n'est pas accessible dans la réalité car la production de courant de chaque cellule du tandem est volontairement différente suivant la région du spectre où elles sont actives et varie en fonction des conditions d'ensoleillement. Il en résulte une limitation intrinsèque du dispositif photovoltaïque à jonction tandem par le plus faible de ses éléments. Une telle limitation en courant réduit fortement le rendement théorique d'un dispositif photovoltaïque à jonction tandem. Une solution consiste à dissocier électriquement les jonctions d'un dispositif photovoltaïque à jonction tandem. Les cellules photovoltaïques du tandem sont toujours couplées optiquement mais sont découplées électriquement. Chaque jonction est alors associée à deux électrodes électriques ; on obtient ainsi un dispositif photovoltaïque à quatre électrodes (dans le cas d'un tandem). En reliant les convertisseurs à chaque (au moins une) cellule photovoltaïque du tandem, le système permet d'obtenir un dispositif photovoltaïque multi-jonctions fonctionnant avec des cellules photovoltaïques découplées électriquement et gérées chacune de manière optimale via le système de gestion selon l'invention.

Les exemples suivants illustrent l'invention sans la limiter.

### Exemple.

Dans cet exemple, on mesure l'effet en terme de perte de rendement de l'application de l'invention.

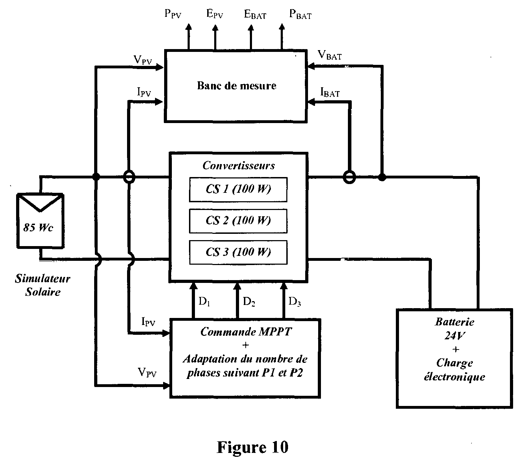

Le protocole de test retenu pour évaluer le gain énergétique apporté par la méthode selon l'invention a consisté à utiliser la même source d'entrée (simulateur solaire) et la même carte de puissance multi-phases (comportement des composants électriques identiques). Le simulateur a permis d'appliquer dans les deux cas le même profil de puissance (par exemple la production d'un module d'une puissance crête de 85 W sur une journée relativement ensoleillée), tandis que l'obtention du MPP a été réalisée par la même commande MPPT, Durant cet essai, une batterie de 24 V a été utilisée, à laquelle a été associée une charge électronique afin de garantir en permanence la tension nominale de cette dernière (24 V). La figure 10 représente le schéma de mesure utilisé.

A partir du banc de mesure on mesure simultanément le courant et la tension présents à l'entrée et à la sortie du convertisseur. Ces valeurs permettent de déduire la puissance PV (PPV) fournie par le simulateur et la puissance transmise à la batterie (PBAT) et donc le rendement du convertisseur (PBAT / PPV). En prenant en compte la variable temps (durée du test en heure) on calcule alors la quantité d'énergie PV produite (EPV) et transférée à la batterie (EBAT).

Les seuils utilisés sont les seuils classiques 1/3 et 2/3.

Le profil de puissance du simulateur est donné à la figure 8.

La valeur du temps de stabilisation t est fixée dans l'exemple à 10 minutes.

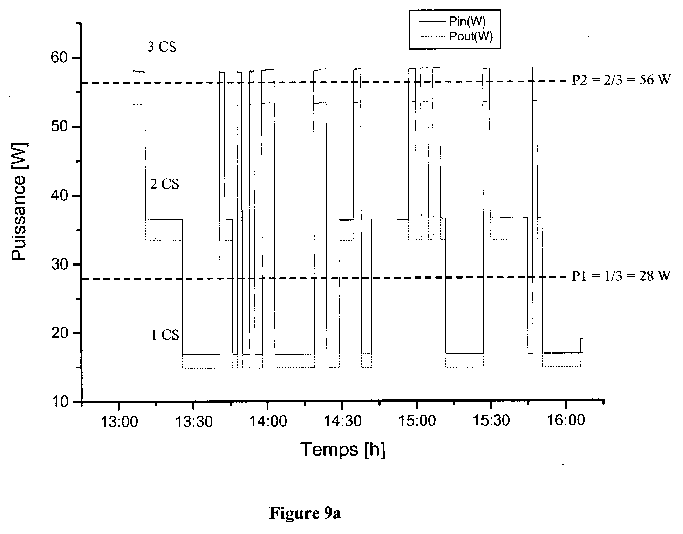

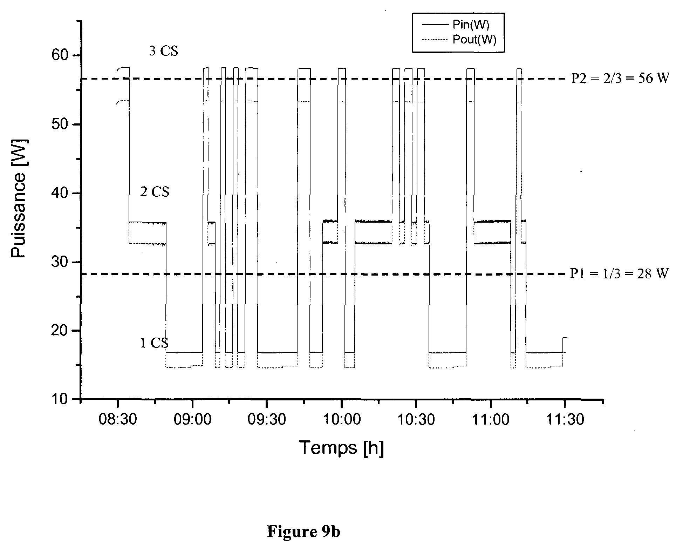

Les figures 9a et 9b représente les valeurs de Pᵢₙ et Pₒᵤₜ dans les cas sans et avec algorithme de l'invention. On remarque dans le cas selon l'invention que lorsque le nombre de CS repasse de 3 à 1, il se produit un léger décroché au niveau de la puissance de sortie, traduisant un gain en terme de rendement (pour les faibles puissances, le rendement est meilleur avec un seul CS).

On obtient les résultats suivants :

| | Énergie PV [Wh] | Énergie Batterie [Wh] | Rendement dc-dc [%] |
|---|---|---|---|
| Comparatif | 96.69 | 87.81 | 90.8 |
| Invention | 96.06 | 86.97 | 90.5 |

D'après ce tableau et comme on pouvait sans douter l'utilisation de cet algorithme affect le rendement de conversion de l'étage de puissance de l'ordre de 0.3%. Cette diminution est cependant encore dans une limite acceptable. En contrepartie, les contraintes thermiques et le stress endurés par les composants sont minimisés, ce qui conduit à une augmentation de la durée de vie de l'étage d'adaptation. Le bilan est positif.

## Revendications

1. Un système de gestion électronique d'un générateur photovoltaïque, le système comprenant :
- une pluralité de n convertisseurs (11, 12, 13) statiques associés en parallèle, chaque convertisseur (11, 12, 13) étant connecté électriquement à au moins une cellule (10) photovoltaïque dudit générateur,
- la variation du nombre de convertisseurs engagés se faisant en fonction de la puissance photovoltaïque générée, par comparaison de la puissance photovoltaïque générée à des seuils P1, P2, ... Pn-1, le nombre de convertisseurs engagés restant identique pendant un temps de temporisation t après passage d'un seuil Pi.

2. Le système selon la revendication 1, dans lequel un déclenchement d'un temps de temporisation t de la variation du nombre de convertisseurs engagés se fait en fonction de la puissance photovoltaïque générée, par comparaison de la puissance photovoltaïque générée à des seuils P1, P2, ... Pn-1.

3. Le système selon la revendication 2, dans lequel le temps de temporisation t de la variation du nombre de convertisseurs engagés est déclenché en cas d'une comparaison entrainant comme réponse une baisse de la puissance photovoltaïque générée.

4. Le système selon l'une des revendications 1 à 3, dans lequel n vaut 3.

5. Le système selon l'une des revendications 1 à 4, dans lequel le temps t de temporisation est compris entre 3 et 20 minutes, de préférence entre 5 et 15 minutes.

6. Le système selon l'une des revendications 1 à 5, dans lequel la valeur du temps t de temporisation dépend de l'état des composants des convertisseurs.

7. Le système selon l'une des revendications 1 à 6, dans lequel la valeur du temps t de temporisation dépend des conditions météorologiques, choisies notamment parmi le lieu d'implantation du générateur et la saison.

8. Le système selon l'une des revendications 1 à 7, dans lequel les convertisseurs sont connectés à tour de rôle.

9. Le système selon la revendication 8, dans lequel la rotation des convertisseurs se fait lors de la variation du nombre de convertisseurs engagés.

10. Le système selon la revendication 8 ou 9, dans lequel la rotation des convertisseurs dépend de l'état des composants des convertisseurs.

11. Un générateur photovoltaïque comprenant :
- au moins une cellule photovoltaïque;
- le système de gestion selon l'une des revendications 1 à 10.

12. Procédé de commande d'un générateur photovoltaïque comprenant
- au moins une cellule photovoltaïque;
- une pluralité de n convertisseurs (11, 12, 13) statiques associés en parallèle, chaque convertisseur (11, 12, 13) étant connecté électriquement à au moins une cellule (10) photovoltaïque;
ledit procédé comprenant les étapes de :
- détermination de la puissance générée par ladite au moins une cellule photovoltaïque et comparaison avec la puissance de crête;
- comparaison avec des valeurs seuils P1, P2, ... Pn-1
- engagement de i convertisseurs lorsque la valeur de puissance mesurée est comprise entre Pi-1 et Pi ou de tous les convertisseurs si la valeur de puissance mesurée est supérieure à Pn-1 ; le nombre de convertisseurs engagés restant identique pendant un temps de temporisation t après passage d'un seuil Pi.

13. Procédé de commande selon la revendication 12, dans lequel on déclenche un temps de temporisation t d'une variation du nombre de convertisseurs engagés en fonction de comparaisons avec des valeurs seuils P1, P2, ... Pn-1.

14. Procédé de commande selon la revendication 13, dans lequel le temps de temporisation t de la variation du nombre de convertisseurs engagés est déclenché en cas d'une comparaison entrainant comme réponse une baisse de la puissance photovoltaïque générée.

15. Procédé de commande selon l'une des revendications 12 à 14, ledit procédé comprenant les étapes suivantes, mises en oeuvre selon des périodes :
- détermination de la puissance générée par ladite au moins une cellule photovoltaïque et comparaison avec la puissance de crête;
- comparaison avec la valeur seuil P1;
(a) si la valeur est inférieure à ce seuil P1, un seul convertisseur est engagé ;
(b) si la valeur est supérieure à ce seuil P1, on compare ensuite à un second seuil P2;
(b1) si la puissance est inférieure à P2, 2 convertisseurs sont engagés ;
(b11) on compare ensuite au premier seuil P1, et si la valeur de puissance est supérieure à ce seuil la routine retourne à l'étape (b) et si la valeur est inférieure à ce seuil P1, il y a déclenchement d'une temporisation t;
(b12) si la temporisation a été déclenchée, on compare ensuite encore au premier seuil P1, et si la valeur de puissance est supérieure à ce seuil la routine retourne à l'étape (b) après avoir remis la temporisation à zéro et si la valeur est inférieure à ce seuil P1, il y a détermination de l'écoulement ou non de la durée de temporisation et si non reprise de la comparaison à la valeur P1;
(b13) lorsque la durée de temporisation est écoulée, il y a alors retour à l'étape (a)
(b2) si la puissance est supérieure à P2, 3 convertisseurs sont connectés;
(b21) on compare ensuite au second seuil P2, et si la valeur de puissance est supérieure à ce seuil la routine retourne à l'étape (b2) et si la valeur est inférieure à ce seuil P2, il y a déclenchement d'une temporisation t;
(b22) si la temporisation a été déclenchée, on compare ensuite encore au second seuil P2, et si la valeur de puissance est supérieure à ce seuil la routine retourne à l'étape (b2) après avoir remis la temporisation à zéro et si la valeur est inférieure à ce seuil P2, il y a détermination de l'écoulement ou non de la durée de temporisation et si non reprise de la comparaison à la valeur P2;
(b13) lorsque la durée de temporisation est écoulée, il y a alors retour à l'étape (a) ou à l'étape (b)
- répétition des étapes le cas échéant pour n convertisseurs.

16. Procédé selon l'une des revendications 12 à 15, dans lequel :
- le ième convertisseur n'étant plus engagé lors de l'engagement des autres convertisseurs lorsque tous les convertisseurs ne sont pas engagés.

17. Procédé selon la revendication 16, ledit procédé comprenant les étapes de
- engagement d'au moins un premier convertisseur ;
- engagement d'un nombre plus élevé de convertisseurs ;
- puis lors de l'engagement d'un nombre moins élevé de convertisseurs, ledit premier convertisseur n'est pas_engagé.

18. Procédé selon la revendication 16 ou 17, dans lequel l'étape de rotation des convertisseurs s'effectue lorsque la valeur de puissance mesurée change entre les seuils Pi-1 et Pi.

19. Procédé selon l'une des revendications 16 à 18, ledit procédé comprenant les étapes de :
- détermination de la durée d'utilisation et/ou du nombre d'utilisation de chaque convertisseur ;
- engagement des convertisseurs tels que la durée d'utilisation et/ou le nombre d'utilisation est sensiblement égal pour les convertisseurs sur une période donnée.

20. Procédé selon l'une des revendications 12 à 19 de commande d'un générateur photovoltaïque selon la revendication 11.

## Patentansprüche

1. System zur elektronischen Steuerung eines Photovoltaikgenerators, wobei das System umfasst:
- eine Vielzahl von n statischen Wandlern (11, 12, 13), die parallelgeschaltet sind, wobei jeder Wandler (11, 12, 13) mit mindestens einer Solarzelle (10) des Generators elektrisch verbunden ist,
- wobei die Variation der Anzahl der verwendeten Wandler in Abhängigkeit von der generierten Solarleistung erfolgt, durch einen Vergleich der generierten Solarleistung mit Schwellen P1, P2, ..., Pn-1, wobei die Anzahl der verwendeten Wandler während einer Verzögerungszeit t nach dem Überschreiten einer Schwelle Pi identisch bleibt.

2. System nach Anspruch 1, wobei ein Auslösen einer Verzögerungszeit t der Variation der Anzahl verwendeter Wandler in Abhängigkeit von der generierten Solarleistung erfolgt, durch einen Vergleich der generierten Solarleistung mit den Schwellen P1, P2, ..., Pn-1.

3. System nach Anspruch 2, wobei die Verzögerungszeit t der Variation der Anzahl verwendeter Wandler im Fall eines Vergleichs ausgelöst wird, der als Antwort ein Absinken der generierten Solarleistung mit sich bringt.

4. System nach einem der Ansprüche 1 bis 3, wobei n gleich 3 ist.

5. System nach einem der Ansprüche 1 bis 4, wobei die Verzögerungszeit t zwischen 3 und 20 Minuten, vorzugsweise zwischen 5 und 15 Minuten, beträgt.

6. System nach einem der Ansprüche 1 bis 5, wobei der Wert der Verzögerungszeit t von dem Zustand der Komponenten der Wandler abhängig ist.

7. System nach einem der Ansprüche 1 bis 6, wobei der Wert der Verzögerungszeit t von Wetterbedingungen abhängig ist, die insbesondere aus dem Ort der Aufstellung des Generators und der Jahreszeit ausgewählt sind.

8. System nach einem der Ansprüche 1 bis 7, wobei die Wandler abwechselnd verbunden sind.

9. System nach Anspruch 8, wobei die Drehung der Wandler bei der Variation der Anzahl verwendeter Wandler erfolgt.

10. System nach Anspruch 8 oder 9, wobei die Drehung der Wandler von dem Zustand der Komponenten der Wandler abhängig ist.

11. Photovoltaikgenerator, umfassend:
- mindestens eine Solarzelle;
- das Steuersystem nach einem der Ansprüche 1 bis 10.

12. Verfahren zur Steuerung eines Photovoltaikgenerators, umfassend:
- mindestens eine Solarzelle;
- eine Vielzahl von n statischen Wandlern (11, 12, 13), die parallelgeschaltet sind, wobei jeder Wandler (11, 12, 13) mit mindestens einer Solarzelle (10) elektrisch verbunden ist;
wobei das Verfahren die Schritte umfasst:
- Bestimmen der Leistung, die von der mindestens einen Solarzelle generiert wird, und Vergleichen mit der maximalen Leistung;
- Vergleichen mit den Schwellenwerten P1, P2, ..., Pn-1;
- Verwenden von i Wandlern, wenn der gemessene Leistungswert zwischen Pi-1 und Pi liegt, oder aller Wandler, wenn der gemessene Leistungswert über Pn-1 liegt; wobei die Anzahl verwendeter Wandler während einer Verzögerungszeit t nach dem überschreiten einer Schwelle Pi identisch bleibt.

13. Steuerverfahren nach Anspruch 12, wobei eine Verzögerungszeit t einer Variation der Anzahl verwendeter Wandler in Abhängigkeit von Vergleichen mit den Schwellenwerten P1, P2, ..., Pn-1 aufgelöst wird.

14. Steuerverfahren nach Anspruch 13, wobei die Verzögerungszeit t der Variation der Anzahl verwendeter Wandler im Fall eines Vergleichs aufgelöst wird, der als Antwort ein Absinken der generierten Solarleistung mit sich bringt.

15. Steuerverfahren nach einem der Ansprüche 12 bis 14, wobei das Verfahren die folgenden Schritte umfasst, die gemäß Perioden durchgeführt werden:
- Bestimmen der Leistung, die von der mindestens einen Solarzelle generiert wird, und Vergleichen mit der maximalen Leistung;
- Vergleichen mit dem Schwellenwert P1;
(a) wenn der Wert kleiner ist als diese Schwelle P1, Verwenden eines einzigen Wandlers;
(b) wenn der Wert größer ist als diese Schwelle P1, anschließendes Vergleichen mit einer zweiten Schwelle P2;
(b1) wenn die Leistung kleiner ist als P2, Verwenden von 2 Wandlern;
(b11) anschließendes Vergleichen mit der ersten Schwelle P1, und, wenn der Leistungswert größer ist als diese Schwelle, Zurückführen der Routine zu dem Schritt (b), und, wenn der Wert kleiner ist als diese Schwelle P1, Auslösen einer Verzögerung t;
(b12) wenn die Verzögerung ausgelöst wurde, anschließendes erneutes Vergleichen mit der ersten Schwelle P1, und, wenn der Leistungswert größer ist als diese Schwelle, Zurückführen der Routine zu dem Schritt (b), nachdem die Verzögerung wieder auf Null gestellt wurde, und, wenn der Wert kleiner ist als diese Schwelle P1, Bestimmen des Ablaufs oder nicht der Verzögerungsdauer, und, wenn nicht, Wiederaufnehmen des Vergleichs mit dem Wert P1;
(b13) wenn die Verzögerungsdauer abgelaufen ist, folglich Zurückführen zu dem Schritt (a);
(b2) wenn die Leistung größer ist als P2, Verbinden von 3 Wandlern;
(b21) anschließendes Vergleichen mit der zweiten Schwelle P2, und, wenn der Leistungswert größer ist als diese Schwelle, Zurückführen der Routine zu dem Schritt (b2), und, wenn der Wert kleiner ist als diese Schwelle P2, Auslösen einer Verzögerung t;
(b22) wenn die Verzögerung aufgelöst wurde, anschließendes erneutes Vergleichen mit der zweiten Schwelle P2, und, wenn der Leistungswert größer ist als diese Schwelle, Zurückführen der Routine zu dem Schritt (b2), nachdem die Verzögerung wieder auf Null gestellt wurde, und, wenn der Wert kleiner ist als diese Schwelle P2, Bestimmen des Ablaufs oder nicht der Verzögerungsdauer, und, wenn nicht, Wiederaufnehmen des Vergleichs mit dem Wert P2;
(b13) wenn die Verzögerungsdauer abgelaufen ist, folglich Zurückführen zu dem Schritt (a) oder zu dem Schritt (b);
- gegebenenfalls Wiederholen der Schritte für n Wandler.

16. Verfahren nach einem der Ansprüche 12 bis 15, wobei :
- der i-te Wandler bei der Verwendung der anderen Wandler nicht verwendet wird, wenn nicht alle Wandler verwendet werden.

17. Verfahren nach Anspruch 16, wobei das Verfahren die Schritte umfasst:
- Verwenden mindestens eines ersten Wandlers;
- Verwenden einer größeren Anzahl von Wandlern;
- anschließendes Nicht-Verwenden des ersten Wandlers bei der Verwendung einer kleineren Anzahl von Wandlern.

18. Verfahren nach Anspruch 16 oder 17, wobei der Schritt des Drehens der Wandler durchgeführt wird, wenn sich der gemessene Leistungswert zwischen den Schwellen Pi-1 und Pi ändert.

19. Verfahren nach einem der Ansprüche 16 bis 18, wobei das Verfahren die Schritte umfasst:
- Bestimmen der Dauer des Einsatzes und/oder der Anzahl der Einsätze jedes Wandlers;
- Verwenden der Wandler derart, dass die Dauer des Einsatzes und/oder die Anzahl der Einsätze für die Wandler in einer gegebenen Periode im Wesentlichen gleich ist.

20. Verfahren nach einem der Ansprüche 12 bis 19 zur Steuerung eines Photovoltaikgenerators nach Anspruch 11.

## Claims

1. System for the electronic management of a photovoltaic generator, the system including:
- a plurality of n static converters (11, 12, 13) connected in parallel, each converter (11, 12, 13) being electrically connected to at least one photovoltaic cell (10) of said generator,
- the variation in the number of converters employed being effected depending on the generated photovoltaic power, through comparison of the generated photovoltaic power with thresholds P1, P2, ... Pn-1, the number of employed converters remaining the same for a lag time t after a threshold Pi has been crossed.

2. System according to Claim 1, in which a lag time t in the variation in the number of employed converters is triggered depending on the generated photovoltaic power, through comparison of the generated photovoltaic power with thresholds P1, P2, ... Pn-1.

3. System according to Claim 2, in which the lag time t in the variation in the number of employed converters is triggered in case of a comparison delivering as response a drop in the generated photovoltaic power.

4. System according to one of Claims 1 to 3, in which n is 3.

5. System according to one of Claims 1 to 4, in which the lag time t lies between 3 and 20 minutes, preferably between 5 and 15 minutes.

6. System according to one of Claims 1 to 5, in which the value of the lag time t depends on the state of the components of the converters.

7. System according to one of Claims 1 to 6, in which the value of the lag time t depends on meteorological conditions, chosen notably according to the installation location of the generator and the season.

8. System according to one of Claims 1 to 7, in which the converters are connected in turn.

9. System according to Claim 8, in which the rotation of the converters is effected in the event of variation in the number of converters employed.

10. System according to Claim 8 or 9, in which the rotation of the converters depends on the state of the components of the converters.

11. Photovoltaic generator, including:
- at least one photovoltaic cell;
- the management system according to one of Claims 1 to 10.

12. Method for controlling a photovoltaic generator including:
- at least one photovoltaic cell;
- a plurality of n static converters (11, 12, 13) connected in parallel, each converter (11, 12, 13) being electrically connected to at least one photovoltaic cell (10);
said method including the steps of:
- determination of the power generated by said at least one photovoltaic cell and comparison with the peak power;
- comparison with threshold values P1, P2, ... Pn-1;
- employment of i converters when the measured power value lies between Pi-1 and Pi or of all the converters if the measured power value is greater than Pn-1; the number of employed converters remaining the same for a lag time t after a threshold Pi has been crossed.

13. Control method according to Claim 12, in which a lag time t in a variation in the number of employed converters is triggered depending on comparisons with threshold values P1, P2, ... Pn-1.

14. Control method according to Claim 13, in which the lag time t in the variation in the number of employed converters is triggered in case of a comparison delivering as response a drop in the generated photovoltaic power.

15. Control method according to one of Claims 12 to 14, said method including the following steps, implemented according to periods:
- determination of the power generated by said at least one photovoltaic cell and comparison with the peak power;
- comparison with the threshold value P1;
(a) if the value is lower than this threshold P1, a single converter is employed;
(b) if the value is higher than this threshold P1, a comparison is then made with a second threshold P2;
(b1) if the power is less than P2, 2 converters are employer;
(b11) a comparison is then made with the first threshold P1, and if the power value is higher than this threshold, the routine returns to step (b), and if the value is lower than this threshold P1, a lag time t is activated;
(b12) if the lag time has been triggered, a comparison is then again made with the first threshold P1, and if the power value is higher than this threshold, the routine returns to step (b) after having reset the lag time, and if the value is lower than this threshold P1, the expiry or not of the lag time period is determined, and, if not, the comparison with the value P1 is resumed;
(b13) when the lag time period has expired, the routine then returns to step (a);
(b2) if the power is greater than P2, 3 converters are connecter;
(b21) a comparison is then made with the second threshold P2, and if the power value is higher than this threshold, the routine returns to step (b2), and if the value is lower than this threshold P2, a lag time t is trigered;
(b22) if the lag time has been trigered, a comparison is then again made with the second threshold P2, and if the power value is higher than this threshold, the routine returns to step (b2) after having reset the lag time, and if the value is lower than this threshold P2, the expiry or not of the lag time period is determined, and, if not, the comparison with the value P2 is resumed;
(b13) when the lag time period has expired, the routine then returns to step (a) or step (b);
- repetition of the steps if necessary for n converters.

16. Method according to one of Claims 12 to 15, in which:
- the ith converter is no longer employed during the connection of the other converters when not all the converters are employed.

17. Method according to Claim 16, said method including the steps of:
- employment of at least one first converter;
- employment of a higher number of converters;
- then, in the event of the employment of a lower number of converters, said first converter is not employed.

18. Method according to Claim 16 or 17, in which the step of rotation of the converters is carried out when the measured power value changes between the thresholds Pi-1 and Pi.

19. Method according to one of Claims 16 to 18, said method including the steps of:
- determination of the duration of use and/or of the number of uses of each converter;
- employment of the converters such that the duration of use and/or the number of uses is more or less equal for the converters over a given period.

20. Method according to one of Claims 12 to 19 for controlling a photovoltaic generator according to Claim 11.
